# EUROPEAN PATENT APPLICATION

(11) **EP 4 761 049 A1**
(43) Date of publication of application: **17.06.2026**
(21) Application number: 25165005.7
(22) Date of filing: 20.03.2025
(51) Int. Cl.: H02J 7/02

(54) **CHARGING DEVICE AND OPERATING METHOD THEREOF**

(30) Priority: 13.12.2024 TW 113148568
(71) Applicant: Wistron Corporation, New Taipei City 22181 (TW)
(72) Inventor: HUANG, Chengwei, 22181 New Taipei City (TW); HUANG, Chih Fong, 22181 New Taipei City (TW)
(74) Representative: Becker, Eberhard

(57) **Abstract**

A charging device (100, 300) and an operating method thereof are provided. The charging device (100, 300) is installed to a power system (200, 400) through a first power line (101, 301), a second power line (102, 302) and a ground line (103, 303). The charging device (100, 300) includes a first processor (110, 310), a second processor (120, 320) and a microcontroller (130, 330). The first processor (110, 310) is coupled to the first power line (101, 301) and the second power line (102, 302) and generates a first voltage determination signal. The second processor (120, 320) is coupled to the second power line (102, 302) and the ground line (103, 303), and generates a second voltage determination signal. The microcontroller (130, 330) is used to determine a power standard of the power system (200, 400) according to the first voltage determination signal and the second voltage determination signal.

## Description

### BACKGROUND

### Technical Field

The disclosure relates to a device, and more particularly, to a charging device and an operating method thereof.

### Description of Related Art

As electric vehicles become increasingly popular in the global market, the demand for charging piles is growing annually worldwide. However, before installing charging pile equipment, installation personnel must configure the internal settings of the charging pile according to the power standards of different countries or regions, so that the charging pile may properly determine the ground monitoring interruption (GMI) function. In this regard, since the power specifications and voltage standards used in the power standards of different countries or regions vary, if installation personnel configure the settings improperly, the ground monitoring interruption function of the charging pile may be mistakenly triggered, causing the charging pile to either fail to perform charging or execute erroneous charging operations.

### SUMMARY

The disclosure provides a charging device and an operating method thereof, which may automatically determine a power standard of a power system.

In an embodiment of the disclosure, a charging device is installed to a power system through a first power line, a second power line, and a ground line. The charging device includes a first processor, a second processor, and a microcontroller. The first processor is coupled to the first power line and the second power line, and is used to generate a first voltage determination signal. The second processor is coupled to the second power line and the ground line, and is used to generate a second voltage determination signal. The microcontroller is coupled to the first processor and the second processor, and is used to determine a power standard of the power system according to the first voltage determination signal and the second voltage determination signal.

In an embodiment of the disclosure, an operating method is applicable to a charging device. The charging device is installed to a power system through a first power line, a second power line, and a ground line. The operating method includes the following steps. The first power line and the second power line are detected through a first processor to generate a first voltage determination signal. The second power line and the ground line are detected through a second processor to generate a second voltage determination signal. A power standard of the power system is determined through a microcontroller according to the first voltage determination signal and the second voltage determination signal.

Based on the above, the charging device and the operating method thereof in the disclosure may effectively determine the power standard of the power system by detecting voltages of the first power line, the second power line, and the ground line.

To make the features and advantages of the disclosure more comprehensible, several embodiments accompanied with drawings are described in detail as follows.

### BRIEF DESCRIPTION OF THE DRAWINGS

FIG. 1 is a schematic diagram of a charging device according to an embodiment of the disclosure.
FIG. 2 is a flowchart of an operating method of a charging device according to an embodiment of the disclosure.
FIG. 3 is a schematic diagram of a charging device according to an embodiment of the disclosure.
FIG. 4 is a schematic diagram of a detection circuit according to an embodiment of the disclosure.
FIG. 5 is a flowchart of an operating method of a charging device according to an embodiment of the disclosure.
FIG. 6 is a schematic diagram of voltage detection results according to an embodiment of the disclosure.

### DESCRIPTION OF THE EMBODIMENTS

Some embodiments of the disclosure will be described in detail below in conjunction with the accompanying drawings. The component symbols referenced in the following descriptions are considered to represent the same or similar components when the same symbols appear in different drawings. These embodiments are only part of the disclosure and do not disclose all possible implementations of the disclosure. More specifically, these embodiments are merely examples of the devices and methods within the scope of the patent application for the disclosure.

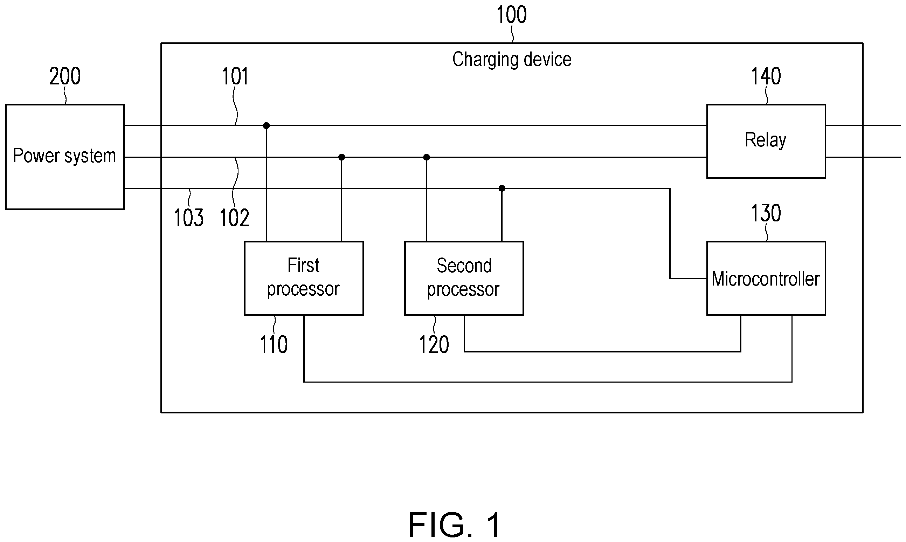

FIG. 1 is a schematic diagram of a charging device according to an embodiment of the disclosure. Referring to FIG. 1, a charging device 100 includes a first power line 101, a second power line 102, a ground line 103, a first processor 110, a second processor 120, a microcontroller 130, and a relay 140. The first power line 101 may be an L power line or an L1 power line, and the second power line 102 may be an N power line or an L2 power line. The ground line 103 may be a protective earthing (PE) line. The microcontroller (MCU) 130 may also be a microprocessor, a digital signal processor (DSP), a complex programmable logic device (CPLD), a field-programmable gate array (FPGA), or a combination of the aforementioned components.

In an embodiment, the charging device 100 is coupled to a power system 200 through the first power line 101, the second power line 102, and the ground line 103. The first processor 110 is coupled to the first power line 101, the second power line 102, and the microcontroller 130. The second processor 120 is coupled to the second power line 102, the ground line 103, and the microcontroller 130. The microcontroller 130 is further coupled to the ground line 103. The relay 140 is coupled to the first power line 101 and the second power line 102.

In an embodiment, the charging device 100 may be a charging pile device for vehicles; however, the disclosure is not limited thereto. The power system 200 may serve as a power source, and the voltage standard of the power system 200 may vary depending on the regulations of different regions or countries. Additionally, the voltage signals obtained by the first power line 101, the second power line 102, and the ground line 103 from the power system 200 are determined based on the voltage standard of the power system 200. In this embodiment, the first processor 110 and the second processor 120 may respectively be meter processors.

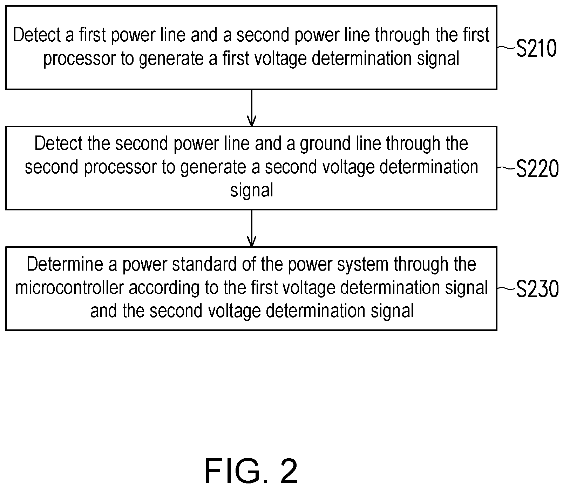

FIG. 2 is a flowchart of an operating method of the charging device according to an embodiment of the disclosure. Referring to FIGs. 1 and 2, the charging device 100 may perform the following steps S210 to S230. In step S210, the first processor 110 may detect the first power line 101 and the second power line 102 to generate a first voltage determination signal. In this embodiment, the first processor 110 may respectively detect the voltages of the first power line 101 and the second power line 102 and generate the first voltage determination signal based on a voltage difference (AC voltage difference) between the first power line 101 and the second power line 102.

In step S220, the second processor 120 may detect the second power line 102 and the ground line 103 to generate a second voltage determination signal. In this embodiment, the second processor 120 may respectively detect the voltages of the second power line 102 and the ground line 103 and generate the second voltage determination signal based on a voltage difference (AC voltage difference) between the second power line 102 and the ground line 103. In step S230, the microcontroller 130 may determine the power standard of the power system 200 according to the first voltage determination signal and the second voltage determination signal.

In an embodiment, in response to the power standard of the power system 200 being a TT power system standard or a TN power system standard, the first power line 101 serves as a live wire (i.e., L power line), and the second power line 102 serves as a neutral wire (i.e., N power line). In response to the power standard of the power system 200 being an IT power system standard, the first power line 101 serves as a first live wire (i.e., L1 power line), and the second power line 102 serves as a second live wire (i.e., L2 power line), where the voltage waveforms of the voltage signals transmitted by the first live wire and the second live wire have the same frequency and phase difference. In this embodiment, the microcontroller 130 may automatically determine whether the power system 200 is a TT power system, a TN power system, or an IT power system according to the first voltage determination signal and the second voltage determination signal, so that the charging device 100 may proceed with subsequent installation and configuration.

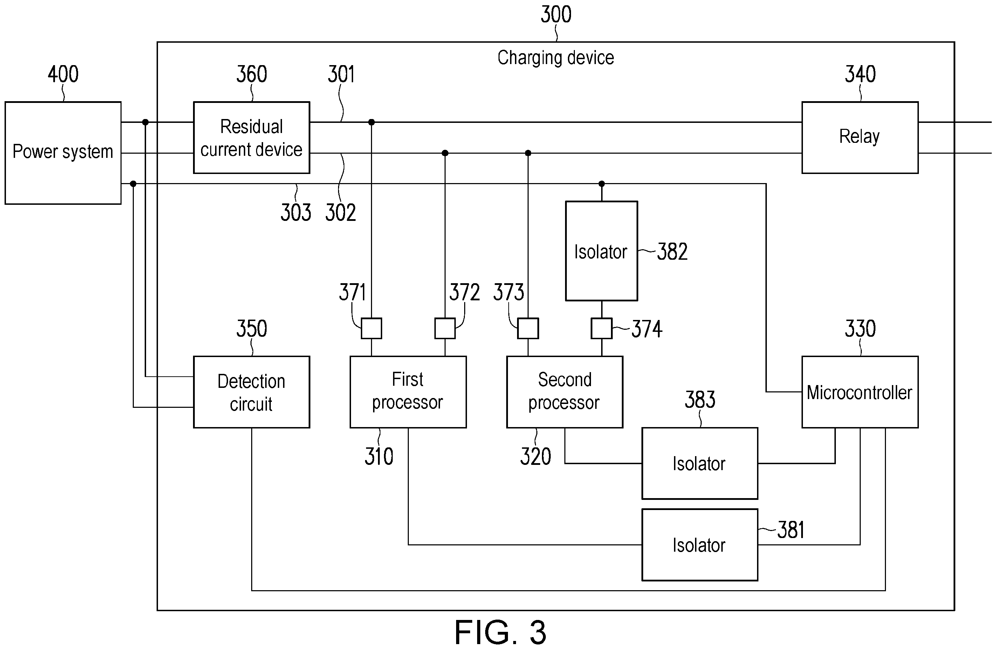

FIG. 3 is a schematic diagram of a charging device according to an embodiment of the disclosure. Referring to FIG. 3, a charging device 300 includes a first power line 301, a second power line 302, a ground line 303, a first processor 310, a second processor 320, a microcontroller 330, a relay 340, a detection circuit 350, a residual current device (RCD) 360, multiple resistor units 371 to 374, and multiple isolators 381 to 383. In this embodiment, the charging device 300 is coupled to a power system 400 through the first power line 301, the second power line 302, and the ground line 303. The resistor units 371 to 374 may each consist of one or more resistors.

In an embodiment, the first processor 310 is coupled to the first power line 301 through the resistor unit 371 and coupled to the second power line 302 through the resistor unit 372. The first processor 310 is also coupled to the microcontroller 330 through the isolator 381. The second processor 320 is coupled to the second power line 302 through the resistor unit 373 and coupled to the ground line 303 through the resistor unit 374 and the isolator 382, where the resistor unit 374 and the isolator 382 are connected in series. The second processor 320 is further coupled to the microcontroller 330 through the isolator 383 to achieve electrical isolation between the primary side and the secondary side.

In an embodiment, the microcontroller 330 is further coupled to the ground line 303. The relay 340 is coupled to the first power line 301 and the second power line 302. The detection circuit 350 is coupled to the first power line 301, the ground line 303, and the microcontroller 330. The residual current device 360 may be disposed on the first power line 301 and the second power line 302.

In an embodiment, the microcontroller 330 may obtain the first voltage determination signal through the first processor 310 and may obtain the second voltage determination signal through the second processor 320. The microcontroller 330 may effectively determine the power standard of the power system 400 based on the first voltage determination signal and the second voltage determination signal. The microcontroller 330 may also detect the first power line 301 and the ground line 303 through the detection circuit 350 to generate a voltage detection signal. In this embodiment, the microcontroller 330 may read a determination formula according to the power standard and determine whether the charging device 330 is properly installed to the power system 400 based on the determination formula and the voltage detection signal.

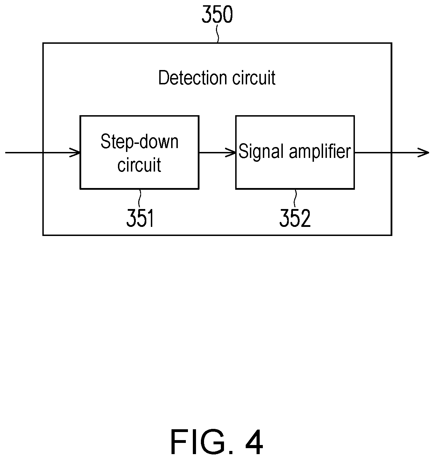

FIG. 4 is a schematic diagram of a detection circuit according to an embodiment of the disclosure. Referring to FIGs. 3 and 4, in this embodiment, the detection circuit 350 may include a step-down circuit 351 and a signal amplifier 352. The step-down circuit 351 is coupled to the signal amplifier 352. The step-down circuit 351 may be coupled to the first power line 301 and the ground line 303 to obtain the voltage difference between the first power line 301 and the ground line 303 and to perform voltage reduction on it. The signal amplifier 352 may amplify the reduced signal output by the step-down circuit 351 to generate the voltage detection signal.

Referring again to FIG. 3, in an embodiment, after the charging device 300 is activated, the first processor 310 may detect the first power line 301 and the second power line 302 to respectively obtain the AC voltage value of the first power line 301 and the AC voltage value of the second power line 302. The first processor 310 may subtract the AC voltage value of the second power line 302 from the AC voltage value of the first power line 301 to obtain the voltage difference between the first power line 301 and the second power line 302 and output the first voltage determination signal, which includes the AC voltage value representing the voltage difference, to the microcontroller 330.

In an embodiment, after the charging device 300 is activated, the second processor 320 may detect the second power line 302 and the ground line 303 to respectively obtain the AC voltage value of the second power line 302 and the AC voltage value of the ground line 303. The second processor 320 may subtract the AC voltage value of the ground line 303 from the AC voltage value of the second power line 302 to obtain the voltage difference between the second power line 302 and the ground line 303 and output the second voltage determination signal, which includes the AC voltage value representing the voltage difference, to the microcontroller 330.

In an embodiment, after the charging device 300 is activated, the detection circuit 350 may detect the first power line 301 and the ground line 303 to respectively obtain the AC voltage value of the second power line 302 and the AC voltage value of the ground line 303. The detection circuit 350 may generate a voltage detection signal based on the AC voltage value of the second power line 302 and the AC voltage value of the ground line 303. In this embodiment, the detection circuit 350 may be used to implement the ground monitoring interruption (GMI) function and output the voltage detection signal, which includes the GMI voltage (DC voltage value) representing the ground monitoring interruption determination result, to the microcontroller 330.

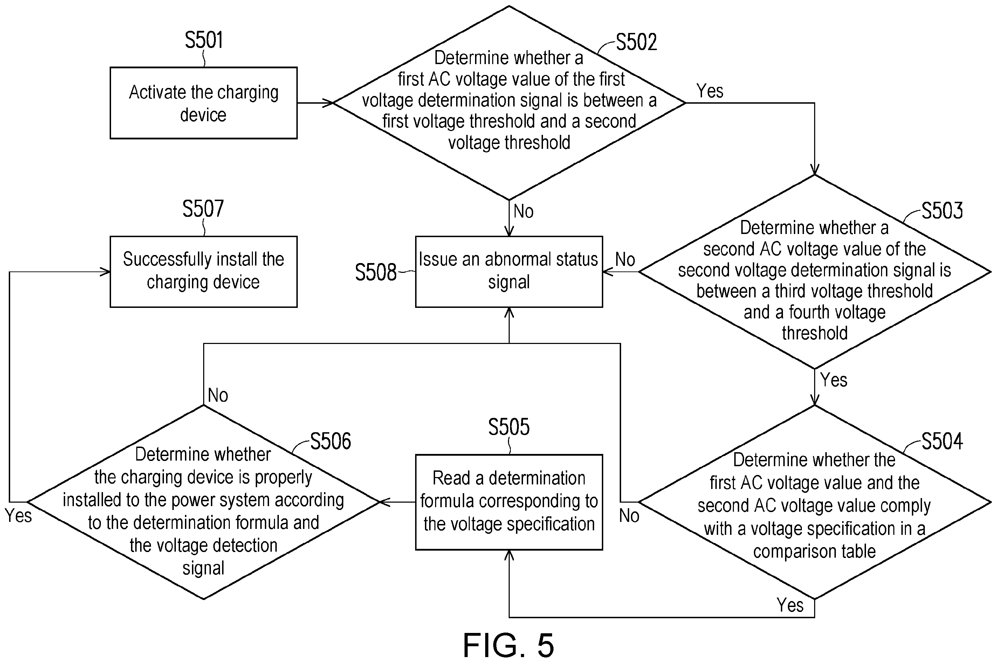

FIG. 5 is a flowchart of an operating method of a charging device according to an embodiment of the disclosure. Referring to FIGs. 3 and 5, the charging device 300 may execute the following steps S501 to S508. In step S501, the charging device 300 is activated. In step S502, the microcontroller 330 may determine whether the first AC voltage value of the first voltage determination signal is between a first voltage threshold and a second voltage threshold. The first voltage threshold is less than the second voltage threshold. If not, in step S508, the microcontroller 330 may issue an abnormal status signal. In this regard, in response to the microcontroller 330 determining that the first AC voltage value of the first voltage determination signal is not between the first voltage threshold and the second voltage threshold, the microcontroller 330 determines that the charging device 300 is not properly installed to the power system 400.

In response to the microcontroller 330 determining that the first AC voltage value of the first voltage determination signal is between the first voltage threshold and the second voltage threshold, in step S503, the microcontroller 330 may further determine whether the second AC voltage value of the second voltage determination signal is between a third voltage threshold and a fourth voltage threshold. The third voltage threshold is less than the fourth voltage threshold. If not, in step S508, the microcontroller 330 may issue an abnormal status signal. In this regard, in response to the microcontroller 330 determining that the second AC voltage value of the second voltage determination signal is not between the third voltage threshold and the fourth voltage threshold, the microcontroller 330 determines that the charging device 300 is not properly installed to the power system 400.

In response to the microcontroller 330 determining that the first AC voltage value of the first voltage determination signal is between the first voltage threshold and the second voltage threshold, and the second AC voltage value of the second voltage determination signal is between the third voltage threshold and the fourth voltage threshold, the microcontroller 330 may read a comparison table. In step S504, the microcontroller 330 may determine whether the first AC voltage value and the second AC voltage value comply with the voltage specification in the comparison table. If not, in step S508, the microcontroller 330 may issue an abnormal status signal. If so, in step S505, the microcontroller 330 reads the comparison table to determine whether the first AC voltage value and the second AC voltage value comply with the voltage specification in the comparison table.

In an embodiment, the comparison table of the microcontroller 330 may pre-store information corresponding to multiple voltage specifications for different power standards and search for matching voltage specifications using the first AC voltage value and the second AC voltage value. If no match is found, in step S508, the microcontroller 330 may issue an abnormal status signal. If a match is found, in step S505, the microcontroller 330 may read the determination formula corresponding to the voltage specification. Notably, the determination formula refers to the ground monitoring interruption (GMI) determination formula. In this regard, different power standards correspond to different GMI determination formulas.

In step S506, the microcontroller 330 may determine, based on the determination formula and the voltage detection signal, whether the charging device is properly installed to the power system 400. If not, in step S508, the microcontroller 330 may issue an abnormal status signal. If so, in step S507, the charging device 300 is successfully installed to the power system 400. In an embodiment, in response to determining that the charging device 300 is successfully installed to the power system 400, the charging device 300 may operate in a standby state. In response to the charging device 300 being coupled to a device to be charged (e.g., a charging module of an electric vehicle) through the first power line 301 and the second power line 302, the charging device 300 may supply power to the device to be charged based on the power signal provided by the power system 400 to perform a charging operation.

For example, the following illustrates the power standards of Taiwan, Japan, the United States, and Europe. As shown in Table 1 below, corresponding to the power standards of Taiwan, Japan, the United States, and Europe, the voltage difference between the first power line 301 and the second power line 302 may be approximately between 180Vac and 264Vac. Therefore, the first voltage threshold may, for example, be set to 180Vac, and the second voltage threshold may, for example, be set to 264Vac, but the disclosure is not limited thereto. Additionally, as shown in Table 1 below, corresponding to the power standards of Taiwan, Japan, the U.S., and Europe, the voltage difference between the second power line 302 and the ground line 303 may be approximately between 0Vac and 132Vac. Therefore, the third voltage threshold may, for example, be set to 0Vac, and the fourth voltage threshold may, for example, be set to 132Vac, but the disclosure is not limited thereto.

**Table 1**

| | Voltage Difference Between First Power Line and Second Power Line | Voltage Difference Between Second Power Line and Ground Line | Power Standard |
|---|---|---|---|
| Taiwan | 198Vac~242Vac (220Vac-10%~220Vac+10%) | <22Vac (220Vac*10%) | TT/TN |
| Japan | 180Vac~220Vac (200Vac-10%~200Vac+10%) | 90Vac~110Vac (100Vac-10%~100Vac+10%) | IT |
| U.S. | 216Vac~264Vac (240Vac-10%~240Vac+10%) | 108~132Vac (120Vac-10%~120Vac+10%) | IT |
| Europe | 207Vac~253Vac (230Vac-10%~230Vac+10%) | <23Vac (230Vac*10%) | TT/TN |

In response to the voltage relationships among the first power line 301, the second power line 302, and the ground line 303 passing the determinations in steps S502 and S503, the microcontroller 330 may further compare whether the two voltage differences satisfy one of the multiple regions listed in Table 1. If so, the microcontroller 330 will read the corresponding ground monitoring interruption (GMI) determination formula to analyze the voltage detection signal provided by the detection circuit 350.

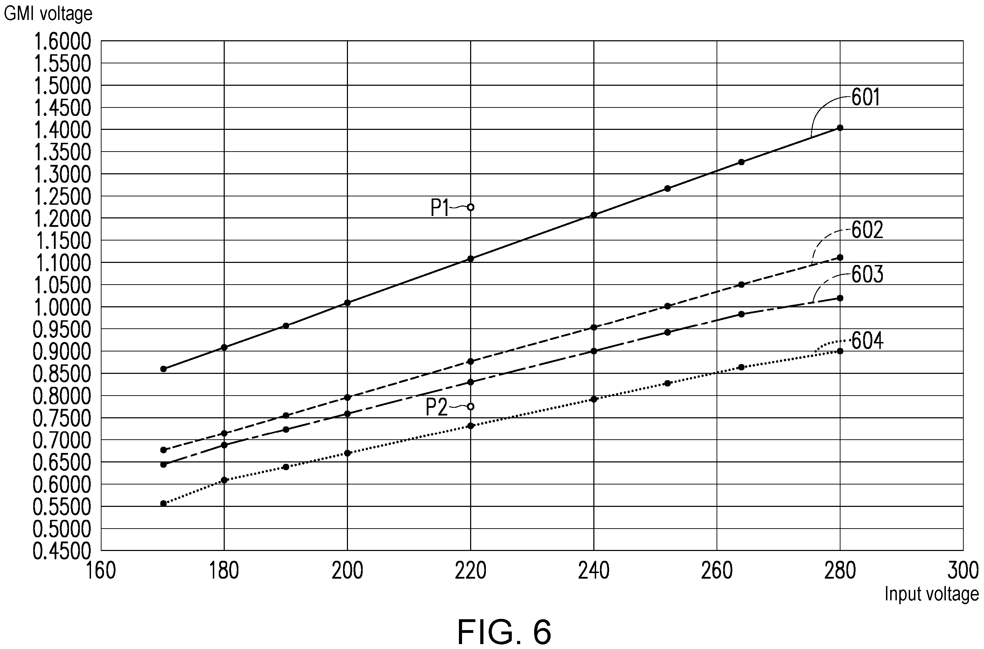

FIG. 6 is a schematic diagram of voltage detection results according to an embodiment of the disclosure. Referring to FIGs. 3, 5, and 6, the ground monitoring interruption (GMI) determination formulas corresponding to the TT power system standard and the TN power system standard may be represented by curves 601 and 602 in FIG. 6. In an embodiment, the upper region of curve 601 represents the recovery area, the lower region of curve 602 represents the trip area for triggering ground monitoring interruption protection, and the area between curve 601 and curve 602 represents the hysteresis area. In this regard, for the cases corresponding to the TT power system standard and the TN power system standard, if the coordinate point corresponding to the GMI voltage of the voltage detection signal and the input voltage provided by the first power line 301 and the second power line 302 falls within the lower region of curve 602, the microcontroller 330 may execute ground monitoring interruption protection. In response to the coordinate point corresponding to the GMI voltage of the voltage detection signal and the input voltage provided by the first power line 301 and the second power line 302 falling within the upper region of curve 601, the microcontroller 330 may deactivate the ground monitoring interruption (GMI) protection mechanism to resume the charging operation of the charging device 300. In response to the coordinate point corresponding to the GMI voltage of the voltage detection signal and the input voltage provided by the first power line 301 and the second power line 302 falling within the tolerance area between curve 601 and curve 602, the microcontroller 330 may refrain from switching the operating mode of the charging device 300 to avoid frequent switching and reduce wear.

In an embodiment, the ground monitoring interruption (GMI) determination formulas corresponding to the IT power system standard may be represented by curves 603 and 604 in FIG. 6. In this embodiment, the upper region of curve 603 represents the trip area for triggering ground monitoring interruption protection, the lower region of curve 604 represents the recovery area, and the area between curve 603 and curve 604 represents the hysteresis area. In this regard, in response to the coordinate point corresponding to the GMI voltage (DC voltage) of the voltage detection signal and the input voltage provided by the first power line 301 and the second power line 302 falling within the upper region of curve 603, the microcontroller 330 may execute ground monitoring interruption protection. In response to the coordinate point corresponding to the GMI voltage of the voltage detection signal and the input voltage provided by the first power line 301 and the second power line 302 falling within the lower region of curve 604, the microcontroller 330 may deactivate the ground monitoring interruption (GMI) protection mechanism to resume the charging operation of the charging device 300. In response to the coordinate point corresponding to the GMI voltage of the voltage detection signal and the input voltage provided by the first power line 301 and the second power line 302 falling within the tolerance area between curve 603 and curve 604, the microcontroller 330 may refrain from switching the operating mode of the charging device 300 to avoid frequent switching and reduce wear.

In other words, if the microcontroller 330 uses an improper ground monitoring interruption (GMI) determination formula to analyze the voltage detection signal, it will result in the charging device 300 operating in an improper mode. Therefore, in this embodiment, the microcontroller 330 may first determine the power system standard of the power system 400 based on the voltage difference between the first power line 301 and the second power line 302, and the voltage difference between the second power line 302 and the ground line 303. The microcontroller 330 may then use the corresponding ground monitoring interruption (GMI) determination formula to effectively and automatically determine whether the charging device 300 is properly grounded.

As another example, referring to FIG. 6 and using the power system standard of Taiwan as an example, the power system standard in Taiwan is either the TT power system standard or the TN power system standard. The microcontroller 330 may first use curves 601 and 602 to determine the coordinate point corresponding to the ground monitoring interruption (GMI) voltage of the voltage detection signal and the input voltage provided by the first power line 301 and the second power line 302. Taking a coordinate point P1 as an example, the coordinate point P1 falls within the upper region of curve 601. Therefore, the microcontroller 330 may deactivate the ground monitoring interruption (GMI) protection mechanism to resume the charging operation of the charging device 300. Taking a coordinate point P2 as another example, the coordinate point P2 falls within the lower region of curve 602. Therefore, the microcontroller 330 may execute ground monitoring interruption protection. In contrast, if curves 603 and 604 corresponding to the IT power system standard were used to determine the coordinate points P1 and P2, misjudgment would occur, resulting in erroneous operation of the charging device 300.

In summary, the charging device and its operating method disclosed herein may automatically detect multiple voltage differences among the first power line, the second power line, and the ground line in the power system. Based on these voltage differences, the power system standard may be determined. This enables the automatic and proper reading of the corresponding ground monitoring interruption (GMI) determination formula and GMI voltage to effectively determine whether the charging device is properly installed.

## Claims

1. A charging device (100, 300), installed to a power system (200, 400) through a first power line (101, 301), a second power line (102, 302) and a ground line (103, 303), the charging device (100, 300) comprising:
a first processor (110, 310), coupled to the first power line (101, 301) and the second power line (102, 302), and used to generate a first voltage determination signal;
a second processor (120, 320), coupled to the second power line (102, 302) and the ground line (103, 303), and used to generate a second voltage determination signal; and
a microcontroller (130, 330), coupled to the first processor (110, 310) and the second processor (120, 320), and used to determine a power standard of the power system (200, 400) according to the first voltage determination signal and the second voltage determination signal.

2. The charging device (100, 300) of claim 1, further comprising:
a detection circuit (350), coupled to the first power line (101, 301), the ground line (103, 303) and the microcontroller (130, 330), and used to generate a voltage detection signal,
wherein the microcontroller (130, 330) reads a determination formula according to the power standard, and the microcontroller (130, 330) determines whether the charging device (100, 300) is properly installed to the power system (200, 400) according to the determination formula and the voltage detection signal,
wherein the determination formula is a ground monitoring interruption determination formula.

3. The charging device (100, 300) of claim 2, wherein the first processor (110, 310) generates the first voltage determination signal according to a voltage difference between the first power line (101, 301) and the second power line (102, 302),
wherein in response to the microcontroller (130, 330) determining a first AC voltage value of the first voltage determination signal not being between a first voltage threshold and a second voltage threshold, the microcontroller (130, 330) determines the charging device (100, 300) not being properly installed to the power system (200, 400),
wherein the first voltage threshold is less than the second voltage threshold.

4. The charging device (100, 300) of claim 3, wherein the second processor (120, 320) generates the second voltage determination signal according to a voltage difference between the second power line (102, 302) and the ground line (103, 303),
wherein in response to the microcontroller (130, 330) determining a second AC voltage value of the second voltage determination signal not being between a third voltage threshold and a fourth voltage threshold, the microcontroller (130, 330) determines the charging device (100, 300) not being properly installed to the power system (200, 400),
wherein the third voltage threshold is less than the fourth voltage threshold.

5. The charging device (100, 300) of claim 4, wherein in response to the microcontroller (130, 330) determining the first AC voltage value of the first voltage determination signal being between the first voltage threshold and the second voltage threshold, and the second AC voltage value of the second voltage determination signal being between the third voltage threshold and the fourth voltage threshold, the microcontroller (130, 330) reads a comparison table to determine whether the first AC voltage value and the second AC voltage value comply with a voltage specification in the comparison table,
wherein in response to the microcontroller (130, 330) determining the first AC voltage value and the second AC voltage value complying with the voltage specification in the comparison table, the microcontroller (130, 330) reads the determination formula corresponding to the voltage specification.

6. The charging device (100, 300) of claim 2, wherein the detection circuit (350) comprises:
a step-down circuit (351), coupled to the first power line (101, 301) and the ground line (103, 303), and used to reduce a voltage difference signal between the first power line (101, 301) and the ground line (103, 303), to generate a reduced voltage difference signal; and
a signal amplifier (352), coupled to the step-down circuit (351), and used to perform a signal amplification on the reduced voltage difference signal to output the voltage detection signal.

7. The charging device (100, 300) of claim 1, wherein in response to the power standard being a TT power system standard or a TN power system standard, the first power line (101, 301) serves as a live wire, and the second power line (102, 302) serves as a neutral wire.

8. The charging device (100, 300) of claim 1, wherein in response to the power standard being an IT power system standard, the first power line (101, 301) serves as a first live wire, and the second power line (102, 302) serves as a second live wire,
wherein a plurality of voltage signals transmitted by the first live wire and the second live wire have a plurality of voltage waveforms with a same frequency and a same phase difference.

9. An operating method of a charging device (100, 300), wherein the charging device (100, 300) is installed to a power system (200, 400) through a first power line (101, 301), a second power line (102, 302) and a ground line (103, 303), the operating method comprising:
detecting the first power line (101, 301) and the second power line (102, 302) through a first processor (110, 310) to generate a first voltage determination signal;
detecting the second power line (102, 302) and the ground line (103, 303) through a second processor (120, 320) to generate a second voltage determination signal; and
determining a power standard of the power system (200, 400) through a microcontroller (130, 330) according to the first voltage determination signal and the second voltage determination signal.

10. The operating method of claim 9, comprising:
detecting the first power line (101, 301) and the ground line (103, 303) through a detection circuit (350) to generate a voltage detection signal;
reading a determination formula through the microcontroller (130, 330) according to the power standard; and
determining whether the charging device (100, 300) is properly installed to the power system (200, 400) through the microcontroller (130, 330) according to the determination formula and the voltage detection signal,
wherein the determination formula is a ground monitoring interruption determination formula.

11. The operating method of claim 10, further comprising:
in response to a first AC voltage value of the first voltage determination signal not being between a first voltage threshold and a second voltage threshold, determining, through the microcontroller (130, 330), the charging device (100, 300) not being properly installed to the power system (200, 400),
wherein the first voltage threshold is less than the second voltage threshold.

12. The operating method of claim 11, further comprising:
in response to a second AC voltage value of the second voltage determination signal not being between a third voltage threshold and a fourth voltage threshold, determining, through the microcontroller (130, 330), the charging device (100, 300) not being properly installed to the power system (200, 400),
wherein the third voltage threshold is less than the fourth voltage threshold.

13. The operating method of claim 12, further comprising:
in response to the first AC voltage value of the first voltage determination signal being between the first voltage threshold and the second voltage threshold, and the second AC voltage value of the second voltage determination signal being between the third voltage threshold and the fourth voltage threshold, reading a comparison table through the microcontroller (130, 330) to determine whether the first AC voltage value and the second AC voltage value meet a voltage specification in the comparison table; and
in response to the first AC voltage value and the second AC voltage value meeting the voltage specification in the comparison table, reading the determination formula corresponding to the voltage specification through the microcontroller (130, 330).

14. The operating method of claim 10, wherein generating the voltage detection signal comprises:
reducing voltage of a voltage difference signal between the first power line (101, 301) and the ground line (103, 303) through a step-down circuit (351) to generate a reduced voltage difference signal; and
amplifying the reduced voltage difference signal through a signal amplifier (352) to output the voltage detection signal.

15. The operating method of claim 9, wherein in response to the power standard being a TT power system standard or a TN power system standard, the first power line (101, 301) serves as a live wire, and the second power line (102, 302) serves as a neutral wire,
wherein in response to the power standard being an IT power system standard, the first power line (101, 301) serves as a first live wire, and the second power line (102, 302) serves as a second live wire, wherein a plurality of voltage signals transmitted by the first live wire and the second live wire have a plurality of voltage waveforms with a same frequency and a same phase difference.
